Europäisches Patentamt

European Patent Office

Office européen des brevets

(11) Veröffentlichungsnummer: **0 293 639**
**A2**

## (12) EUROPÄISCHE PATENTANMELDUNG

(21) Anmeldenummer: **88107420.7**

(22) Anmeldetag: **09.05.88**

(51) Int. Cl.4: **G01D 4/00**

(30) Priorität: **14.05.87 DE 3716019**

(43) Veröffentlichungstag der Anmeldung:
**07.12.88 Patentblatt 88/49**

(84) Benannte Vertragsstaaten:
**AT BE CH DE ES FR GB GR IT LI LU NL SE**

(71) Anmelder: **GAS-, ELEKTRIZITÄTS- UND WASSERWERKE KÖLN AG.**

**D-5000 Köln 1(DE)**

(72) Erfinder: **Lohrer, Edgar, Dipl.-Ing.**
**Dürerstrasse 23**
**D-5020 Frechen-Königsdorf(DE)**
Erfinder: **Vossen, Rolf**
**Vitalisstrasse 382**
**D-5000 Köln 41(DE)**

(74) Vertreter: **Koepsell, Helmut, Dipl.-Ing.**
**Mittelstrasse 7**
**D-5000 Köln 1(DE)**

(54) **Einrichtung zur Erfassung, Speicherung und/oder Beeinflussung von Verbrauchszählern.**

(57) Eine Einrichtung zur Erfassung, Speicherung und/oder Beeinflussung von Verbrauchszählern mit einem Microcomputer (1) sowie Speichervorrichtungen zum Speichern von Arbeitsprogrammen und von abgelesenen Daten sowie Ein/-Ausgabeeinheiten (3.1...3n, 4.1...4.m) zum Anschluß mehrerer elektrisch abfragbarer und gegebenenfalls ansteuerbarer Zähler für unterschiedliche Medien. Hierbei sind Schnittstellen für Impulszähler (6, 7, 8) als auch Schnittstellen für serielle Zähler (5) vorgesehen. Den ansteuerbaren Zählern können programmgesteuert Ansteuersignale zugeführt werden. Die Einrichtung kann zur Bedienung vor Ort über eine Schnittstelle (9) an ein Ein/Ausgabeterminal angeschlossen sein, sie kann aber auch zur Fernbedienung über eine Schnittstelle (10) an ein Datenübertragungsnetz angeschlossen sein. Die Einrichtung kann auch als Fernwirkanlage zur Steuerung und Überwachung von Prozessen eingesetzt werden.

EP 0 293 639 A2

Die Erfindung betrifft eine Einrichtung zur Erfassung, Speicherung und/oder Beeinflussung von Verbrauchszählern mit den Merkmalen aus dem Oberbegriff des Patentanspruches 1.

Derartige Einrichtungen sind grundsätzlich bekannt, beispielsweise in der Form eines elektronischen Maximumwerkes, an das Elektrizitätszähler fest angeschlossen werden können. Die Einrichtung speichert nicht nur die vom Zähler abgegebenen Mengenimpulse, sondern sie ist auch in der Lage beispielsweise am Ende einer Meßperiode den Leistungsmittelwert mit dem höchsten gespeicherten Mittelwert der laufenden monatlichen Rückstellperiode zu vergleichen und diesen bei Überschreitung zu ersetzen. Das Ablesen der Meßwerte kann bei der bekannten Einrichtung entweder von Hand oder mittels eines tragbaren sogenannten Tarifgeräte-Terminals abgelesen werden, wobei letzteres von der Bedienungsperson nacheinander an mehrere Elektrizitätszähler angeschlossen werden kann, wobei die abgelesenen Werte beispielsweise in einem als Kleinkassette ausgebildeten Speicher festgehalten werden können. Weiterhin ist es auch möglich, die bekannte Einrichtung über eine serielle Datenschnittstelle an ein Netz zur Datenfernübertragung anzuschließen.

Ein Nachteil der bekannten Einrichtung besteht darin, daß sie jeweils an Zählern fest installiert werden muß und auch nur jeweils die Meßergebnisse diese Zähler verarbeitet. Ein weiterer Nachteil der bekannten Einrichtung besteht darin, daß sie nur an Impulszähler und Maximumwerke angeschlossen werden kann.

Die der Erfindung zugrunde liegende Aufgabe bestand darin, eine Einrichtung der im Oberbegriff des Patentanspruchs 1 angegebenen Art zu - schaffen, mit der eine zentrale Einzelablesung von Zählern unterschiedlichen Typs und für unterschiedliche Medien, die an verschiedenen Orten auf dem Gelände bzw. in einem Gebäude installiert sind, ermöglicht wird. Hierbei sollte es zusätzlich möglich sein, den Zählern Ansteuersignale zuzuführen, d.h. beispielsweise eine Parametrierbarkeit hinsichtlich Zählerstand und Zählernummer nach einem Zählertausch zu ermöglichen. Weiterhin sollte die Kontrolle aller Leitungen der angeschlossenen Zähler auf Manipulation bezüglich Unterbrechung und Kurzschluß sowie eine Erfassung der Zählerinformationen aller Medien auch bei Netzausfall möglich sein. Schließlich sollte es möglich sein, die Einrichtung an ein Datenübertragungsnetz anzuschließen, so daß sowohl die Ablesung aller angeschlossenen Zählereinrichtungen zur gleichen Zeit von einer Zentrale aus der Ferne erfolgen kann und daß andererseits ebenfalls zentral aus der Ferne Steuersignale zum Sperren und Freischalten sowie zur Rückstellung, zur Tarifschaltung, zur Laststeuerung usw. zugeführt werden können.

Die Lösung dieser Aufgabe erfolgt mit den Merkmalen aus dem kennzeichnenden Teil des Patentanspruchs 1.

Vorteilhafte Ausführungsformen der erfindungsgemäßen Einrichtung sind in den Unteransprüchen beschrieben.

An die erfindungsgemäße Einrichtung sind Verbrauchszähler für unterschiedliche Medien anschließbar. Typische Anwendungsfälle sind beispielsweise die Stromzählung, die Gaszählung, die Wasserzählung, die Fernwärmezählung, aber auch beispielsweise die Datenerfassung von Umweltschutzstationen. Bei einer Installierung der Einrichtung vor Ort ist die konzentrierte fehlerfreie Abfrage der Zählerstände unterschiedlicher Medien an einer Stelle möglich, wobei unterschiedliche Zählertypen, nämlich sowohl Impulszähler als auch serielle Zähleinrichtungen angeschlossen werden können. Der Anschluß an ein Datenübertragungsnetz bringt zusätzliche Vorteile durch die gleichzeitige Ablese- und Ansteuermöglichkeit der Verbrauchszähler von einer Zentrale aus.

Es ist weiterhin möglich, die erfindungsgemäße Einrichtung zu erweitern, indem an die als Grundmodul ausgebildete, beispielsweise in einem Gebäude angeordnete Einrichtung, über eine zusätzliche Schnittstelle ein serieller Datenbus angeschlossen ist (s. Anspruch 5), an den weitere räumlich verzweigte, beispielsweise in anderen Gebäuden installierte Informationsquellen und/-oder -senken angeschlossen sind.

Im folgenden werden anhand der beigefügten Zeichnungen zwei Ausführungsbeispiele für eine Einrichtung nach der Erfindung näher erläutert.

In den Zeichnungen zeigen:

Fig. 1 in einem Blockschaltbild eine Einrichtung zur Erfassung, Speicherung und/oder Beeinflussung von Verbrauchszählern;

Fig. 2 in einer Darstellung analog Fig. 1 eine Erweiterung der Einrichtung nach Fig. 1.

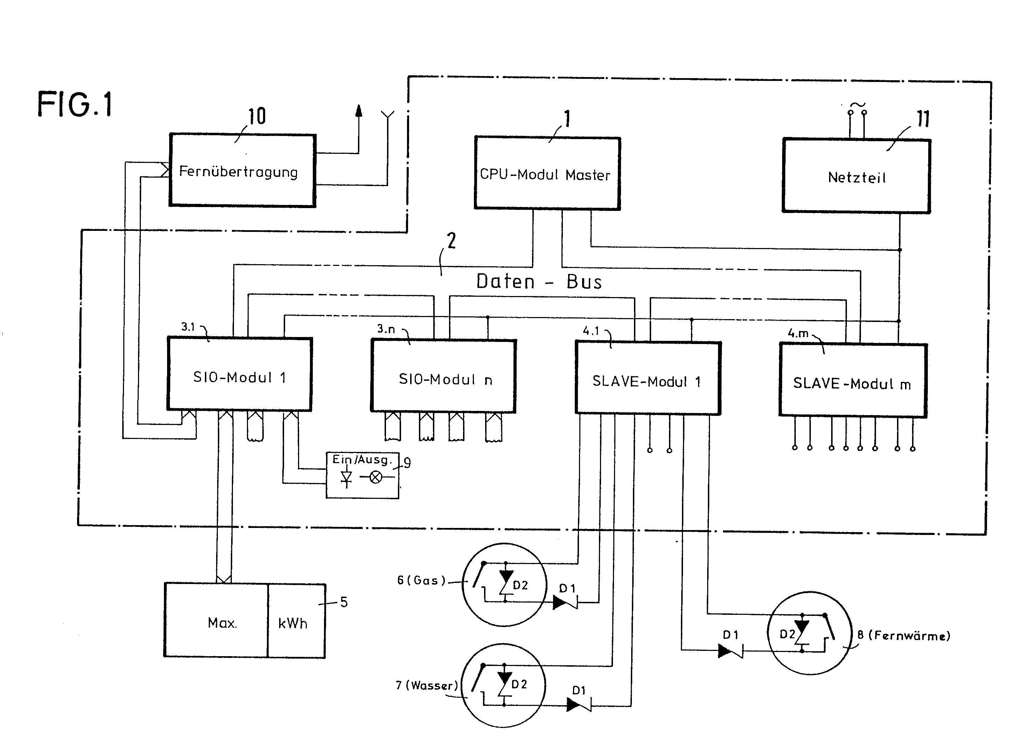

Fig. 1 zeigt in einem Blockschaltbild eine Einrichtung zur Erfassung, Speicherung und/oder Beeinflussung von Verbrauchszählern, wie sie beispielsweise in einem größeren Gebäudekomplex zur Ablesung sämtlicher dort installierten Verbrauchszähler aufgestellt werden kann. Die Einrichtung besitzt einen Mikrocomputer 1, der als Master-Modul ausgebildet ist und von dem aus die Gesamtsteuerung der Einrichtung erfolgt. An den Mikrocomputer 1 sind über Datenbusleitungen 2 Ein/Ausgabeeinheiten angeschlossen, und zwar mehrere als SIO-Modul ausgebildete Einheiten 3.1 bis 3.n, die zum Anschluß von unterschiedlichen seriellen Zähleinrichtungen geeignet sind und mehrere als Slave-Modul ausgebildete Einheiten 4.1 bis 4.m, die zum Anschluß von Impulszählern geeignet sind.

Die Einheiten sind so ausgelegt, daß jeweils mehrere Geräte anschließbar sind. So kann beispielsweise jede der Einheiten 3.1 bis 3.n vier Ein/Ausgänge aufweisen und jede der Einheiten 4.1 bis 4.m kann mit 16 Anschlüssen versehen sein.

In der Zeichnung sind jeweils nur beispielhaft einige Anschlußmöglichkeiten ausgeführt. Selbstverständlich können an die freigehaltenen Ausgänge entsprechende Geräte angeschlossen sein.

So ist beispielsweise an die Ein/Ausgabeeinheit 3.1 ein Elektrizitätszähler 5 angeschlossen, und zwar über ein Maximumwerk, das serielle Daten abgibt. An die gleiche Einheit kann noch ein zweiter Zähler dieses Typs angeschlossen werden. Weiterhin ist an diese Einheit eine Schnittstelle 10 zum Anschluß der Einrichtung an ein Datenübertragungsnetz angeschlossen und eine Schnittstelle 9 zum Anschluß eines Ein/Ausgabeterminals, die als optoelektronische Schnittstelle ausgebildet ist.

An die Einheit 4.1 sind als Beispiel drei Impulszähler für unterschiedliche Medien angeschlossen, nämlich ein Zähler 6 für Gas, ein Zähler 7 für Wasser und ein Zähler 8 für Fernwärme. Die von diesen Zählern abgegebenen binären Signale werden im Slave-Modul verarbeitet. Die Einheiten 4.1 bis 4.m enthalten jeweils einen Mikrocomputer und an jede der Einheiten können beispielsweise bis zu 16 Impulszähler angeschlossen werden. Auf diese Weise wird eine Entlastung des Mikrocomputers 1 bei hoher Zähleranzahl erreicht. Von einem Netzteil 11 aus wird den einzelnen Teilen der Einrichtung die Betriebsspannung zugeführt. In den Einheiten sind zusätzliche Spannungsversorgungsvorrichtungen, beispielsweise Akkumulatoren, angeordnet, die er ermöglichen, eine Verarbeitung der Zählimpulse auch bei begrenztem Netzausfall, beispielsweise bei einer Ausfallzeit von einer Stunde, durchzuführen. Wenn der Netzteil 11 gepuffert ausgeführt ist, kann bei einem Netzausfall auch eine Datenfernübertragung und eine Zuführung von Umsteuersignalen erfolgen. Weiterhin enthalten diese Einheiten Vorrichtungen zur Leitungsüberwachung auf Kurzschluß- oder Leitungsunterbrechung, die in regelmäßigen Zeitabständen eine Überprüfung der Leitungen vornehmen.

Um diese Überprüfung zu ermöglichen, sind in den Zählern 6, 7 und 8 den impulsgebenden Kontakten jeweils eine Zenerdiode D1 vorgeschaltet und eine weitere Zenerdiode D2 parallel geschaltet. Die sich dadurch bei geschlossenen und geöffneten Kontakten einstellenden vorgegebenen Spannungswerte werden in vorgegebenen Zeitabständen überwacht.

Die Bedienung der Einrichtung, also das Ablesen und Ausspeichern von Daten, sowie das Parametrieren, ist vor Ort möglich, indem an die Schnittstelle 9 ein entsprechendes Ein/Ausgabeterminal angeschlossen wird. Bei Fernbedienung erfolgen die entsprechenden Ablese- und Steuervorgänge über die Schnittstelle 10.

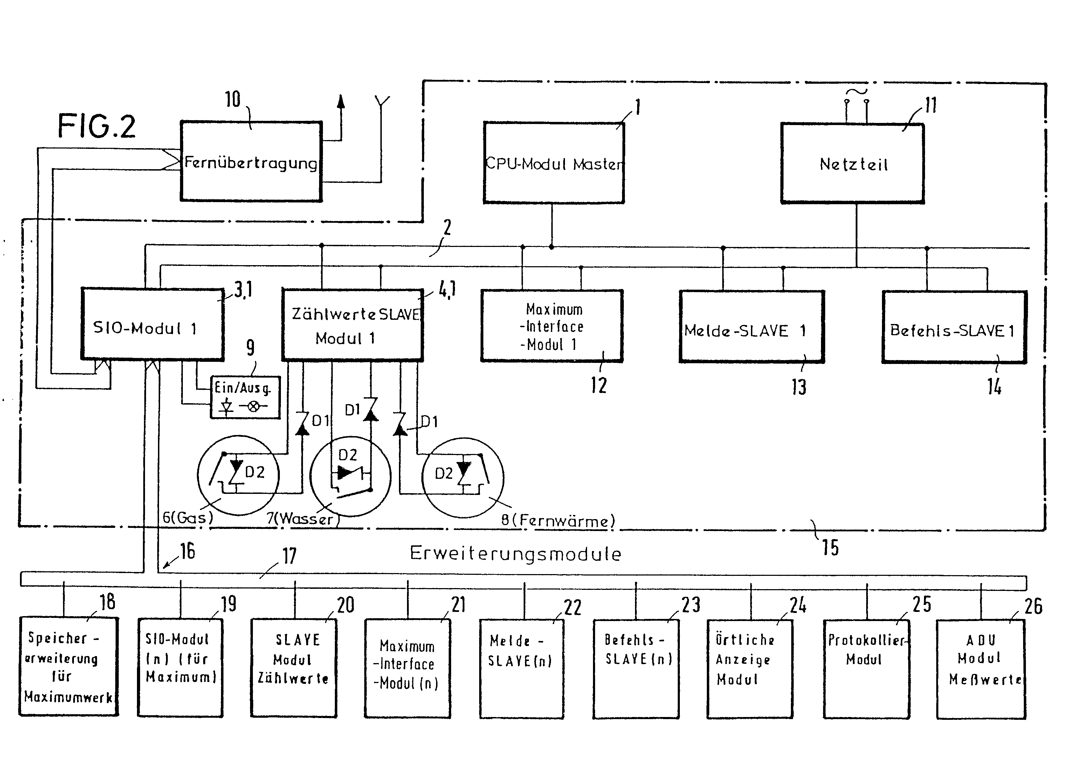

Fig. 2 zeigt eine Erweiterung der Einrichtung nach Fig. 1. Die Teile der Einrichtung nach Fig. 2, die mit entsprechenden Einrichtungsteilen nach Fig. 1 identisch sind, sind in Fig. 2 mit der gleichen Bezugsziffer wie in Fig. 1 bezeichnet.

Die Einrichtung nach Fig. 2 besteht aus einem Grundmodul 15, das beispielsweise in einem zentralen Gebäude einer Gruppe von Gebäuden angeordnet sein kann, zur Ablesung sämtlicher dort installierter Verbrauchszähler. Wie bereits beschrieben, ist im Grundmodul 15 der Mikrocomputer 1 angeordnet, an den über Datenbusleitungen 2 Ein/Ausgabeeinheiten angeschlossen sind. Von den als SIO-Modul ausgebildeten Einheiten ist in Fig. 2 nur eine Einheit 3.1 dargestellt, die zum Anschluß von unterschiedlichen seriellen Zähleinrichtungen geeignet ist.

Selbstverständlich können mehrere derartiger Einheiten vorgesehen sein.

Von den als Slave-Modul ausgebildeten Einheiten ist in Fig. 2 ebenfalls nur eine Einheit 4.1 dargestellt, die zum Anschluß von Impulszählern 6, 7 und 8 geeignet ist.

Auch hier können mehrere derartiger Einheiten vorhanden sein. Zusätzlich zu diesen Einheiten sind an den Datenbus 2 noch angeschlossen eine Einheit 12, die als "Maxi mum-Interface-Modul 1" bezeichnet ist. An die Einheit 12 sind Leistungsmeßwerke mit seriellem Datenausgang anschließbar.

Weiterhin sind im Grundmodul eine Einheit 13, die als "Melde-Slave 1" bezeichnet ist und eine Einheit 14, die als "Befehls-Slave 1" bezeichnet ist, angeschlossen. Über die Einheit 13 sind zusätzliche Daten an den Mikrocomputer 1 übertragbar von Geräten aus, die binäre Werte (Betriebszustände) abgeben und Informationen liefern, oder auch über Manipulationen an anderen angeschlossenen Geräten. Über die Einheit 14 werden Daten vom Mikrocomputer 1 aus an andere angeschlossene Geräte übermittelt, beispielsweise Befehle zur Abschaltung von Anlagen bei Zahlungsverzug oder zur Einschaltung von Notstromeinrichtungen.

Das Grundmodul 15 ist durch eine Reihe von Erweiterungsmodulen ergänzt, die beispielsweise in anderen Gebäuden angeordnet sein können und die über einen seriellen Datenbus 17 und eine Schnittstelle 16 an die Einheit 3.1 im Grundmodul 15 angeschlossen sind.

An den Datenbus 17 können im Prinzip die gleichen Einrichtungen angeschlossen sein, die innerhalb des Grundmoduls 15 an den Datenbus 2 angeschlossen sind. Es können hier aber noch zusätzliche Vorrichtungen installiert werden.

So können beispielsweise folgende, nur beispielhaft aufgezählte zusätzliche Einheiten vorhanden sein:

Eine Einheit 18 zur Speichererweiterung des Moduls (Einheit) 19;

eine Einheit 19 ist ein Maximum-Modul und übt die Funktionen wie das in der Fig. 1 dargestellte Maximumwerk aus. An die Einheit 19 werden Impulszähler angeschlossen. Das Maximum-Modul ist in der Lage, beispielsweise am Ende einer Meßperiode, den Leistungsmittelwert mit dem höchsten gespeicherten Mittelwert der laufenden monatlichen Rückstellperiode zu vergleichen und diesen die Überschreitung zu ersetzen;

eine Einheit 20, die analog der Einheit 4.1 als Slave-Modul ausgebildet ist zur Aufnahme weiterer von Impulszählern gelieferter Zählwerte;

eine Einheit 21, die analog der Einheit 12 als Maximum-Interface-Modul ausgebildet ist;

eine Einheit 22, die analog der Einheit 13 als Melde-Slave ausgebildet ist;

eine Einheit 23, die analog der Einheit 14 als Befehls-Slave ausgebildet ist;

eine Einheit 24, die als Modul für örtliche Anzeige von Verbrauchswerten ausgebildet sein kann;

eine Einheit 25, die als "Protokollier-Modul" bezeichnet ist und beispielsweise als Drucker oder Schreiber ausgebildet sein kann;

eine Einheit 26, die als "ADU-Modul-Meßwerte" bezeichnet ist und an die Geräte angeschlossen sein können, welche Meßwerte physikalischer Größen, wie beispielsweise Druck, Temperatur u. dgl. bilden und diese in analoger Form an die Einheit 26 weitergeben, wo sie in serielle Daten umgewandelt werden.

Es ist weiterhin möglich, anstelle der bekannten Maximumwerke, die im Viertelstundentakt Meßwerte abspeichern, Einheiten vorzusehen, die zum Zwecke der Leistungserfassung innerhalb bestimmter Zeiträume mit anderen, beispielsweise vorgebbaren Abfragetakten arbeiten, also etwa in einem 100 Stunden-Takt arbeiten.

## Ansprüche

1. Einrichtung zur Erfassung, Speicherung und/oder Beeinflussung von Verbrauchszählern mit einem Mikrocomputer sowie Speichervorrichtungen zum Speichern von Arbeitsprogrammen und von abgelesenen Daten und einer Eingabeeinheit zum Anschluß der Einrichtung an den Verbrauchszähler sowie eine Ausgabeeinheit zum Anschluß von datenspeichernden bzw. datenübertragenden Einrichtungen, dadurch gekennzeichnet, daß die Eingabeeinheit als Ein/Ausgabeeinheit ausgebildet ist und Vorrichtungen (3.1...3.n, 4.1...4.m) zum Anschluß mehrerer elektrisch abfragbarer und gegebenenfalls elektrisch ansteuerbarer Zähler (5, 6, 7, 8) für unterschiedliche Medien aufweist, wobei sowohl Schnittstellen (4.1...4.m) für Impulszähler (6, 7, 8) mit Vorrichtungen zur Leitungsüberprüfung als auch Schnittstellen (3.1...3.n) für serielle Zähler (5) vorgesehen sind und über die Ein-Ausgabeeinheit den ansteuerbaren Zählern (5) Ansteuersignale zuführbar sind.

2. Einrichtung nach Anspruch 1, dadurch gekennzeichnet, daß eine weitere Schnittstelle (9) zum Anschluß eines Ein/Ausgabeterminals vorgesehen ist.

3. Einrichtung nach Anspruch 2, dadurch gekennzeichnet, daß die Schnittstelle (9) zum Anschluß eines Ein/Ausgabeterminals als optische Schnittstelle ausgebildet ist.

4. Einrichtung nach einem der Ansprüche 1 bis 3, dadurch gekennzeichnet, daß eine Schnittstelle (10) zum Anschluß der Einrichtung an ein Datenübertragungsnetz vorgesehen ist.

5. Einrichtung nach einem der Ansprüche 1 bis 4, dadurch gekennzeichnet, daß mindestens eine zusätzliche Schnittstelle (16) zum Anschluß eines seriellen Datenbusses (17) vorgesehen ist, an welchen räumlich verzweigte Vorrichtungen (18 - 26) zur Abgabe und/oder Aufnahme von Informationen angeschlossen sind.

FIG.1

| | | |
|---|---|---|
| 10 Fernübertragung | 1 CPU-Modul Master | 11 Netzteil |

2 Daten - Bus

| 3.1 SIO-Modul 1 | 3.n SIO-Modul n | 4.1 SLAVE-Modul 1 | 4.m SLAVE-Modul m |
|---|---|---|---|

Ein/Ausg. 9

Max. | kWh — 5

6 (Gas) D2 D1

7 (Wasser) D2 D1

D1 D2 8 (Fernwärme)

EP 0 293 639 A2

Gw 102 EU

# FIG.2

10 — Fernübertragung

1 — CPU-Modul Master

11 — Netzteil

2

3,1 — SIO-Modul 1

9 — Ein/Ausg.

4,1 — Zählwerte SLAVE Modul 1

Maximum -Interface -Modul 1 — 12

Melde-SLAVE 1 — 13

Befehls-SLAVE 1 — 14

D1 · D2 · 6(Gas)

D1 · D2 · 7(Wasser)

D1 · D2 · 8(Fernwärme)

15

16   17   Erweiterungsmodule

18 — Speicher - erweiterung für Maximumwerk

19 — SIO-Modul (n) (für Maximum)

20 — SLAVE Modul Zählwerte

21 — Maximum -Interface -Modul (n)

22 — Melde - SLAVE(n)

23 — Befehls- SLAVE(n)

24 — Örtliche Anzeige Modul

25 — Protokollier- Modul

26 — ADU Modul Meßwerte

EP 0 293 639 A2

GW 102 EU